(19) Europäisches Patentamt
European Patent Office
Office européen des brevets

(11) EP 3 006 972 A1

(12) **EUROPEAN PATENT APPLICATION**
published in accordance with Art. 153(4) EPC

(43) Date of publication:
**13.04.2016 Bulletin 2016/15**

(21) Application number: **14820658.4**

(22) Date of filing: **17.06.2014**

(51) Int Cl.:
***G02B 5/30*** (2006.01) ***C08J 5/18*** (2006.01)
***H01L 41/193*** (2006.01)

(86) International application number:
**PCT/JP2014/066075**

(87) International publication number:
**WO 2015/001956 (08.01.2015 Gazette 2015/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **04.07.2013 JP 2013140900**

(71) Applicant: **Mitsui Chemicals, Inc.**
**Tokyo 105-7117 (JP)**

(72) Inventors:
- **SATO, Keisuke**
  **Nagoya-shi**
  **Aichi 457-8522 (JP)**
- **TANIMOTO, Kazuhiro**
  **Sodegaura-shi**
  **Chiba 299-0265 (JP)**

(74) Representative: **Hoffmann Eitle**
**Patent- und Rechtsanwälte PartmbB**
**Arabellastraße 30**
**81925 München (DE)**

# (54) FILM AND POLYMERIC PIEZOELECTRIC MATERIAL

(57) A film having a molecular orientation; having an absolute difference ΔRe between the maximum and minimum retardations Re of 100 nm or less in a case wherein the retardations Re are measured at every 0.8 mm along a measured length of 10 mm centered at the center of a principal plane of the film and at a wavelength of 550 nm; and having an average Re (ave) of the retardations Re in a range of from 700 nm to 900 nm or in a range of from 1250 nm to 1450 nm.

EP 3 006 972 A1

## Description

### Technical Field

The present invention related to a film and a polymeric piezoelectric material.

### Background Art

Films have been heretofore used in various applications such as packaging materials and optical materials.

In the various applications, films that have a molecular orientation, such as, for example, stretched films, may be used.

For example, touch panels and touch input devices that include a polylactic acid film having a molecular orientation are known (see, for example, WO 2010/143528).

## SUMMARY OF INVENTION

### Problem to be Solved by the Invention

It has been found that films having a molecular orientation may exhibit visually noticeable color non-uniformity.

Thus, an object of the invention is to provide a film that exhibits reduced color non-uniformity and a polymeric piezoelectric material including the film.

### Means of Solving the Problem

Specific measures of solving the problem are as follows:

<1> A film having a molecular orientation; having an absolute difference $\Delta$Re between the maximum and minimum retardations Re of 100 nm or less in a case in which the retardations Re are measured at every 0.8 mm along a measured length of 10 mm centered at the center of a principal plane of the film and at a wavelength of 550 nm; and having an average Re (ave) of the retardations Re in a range of from 700 nm to 900 nm or in a range of from 1250 nm to 1450 nm.

<2> The film according to <1>, the film having a molecular orientation ratio MOR in a range of from 3.0 to 4.0 or in a range of from 5.5 to 6.5, as measured by a microwave molecular orientation meter.

<3> The film according to <2>, the film having the average Re (ave) in a range of from 700 nm to 900 nm and the molecular orientation ratio MOR in a range of from 3.0 to 4.0, or having the average Re (ave) in a range of from 1250 nm to 1450 nm and the molecular orientation ratio MOR in a range of from 5.5 to 6.5.

<4> The film according to any one of <1> to <3>, the film including a helical chiral polymer having optical activity.

<5> The film according to any one of <1> to <4>, the film having the absolute difference $\Delta$Re of from 20 nm to 100 nm.

<6> The film according to any one of <1> to <5>, the film having the absolute difference $\Delta$Re of from 30 nm to 100 nm.

<7> The film according to any one of <1> to <6>, the film being a uniaxially stretched film.

<8> The film according to any one of <1> to <7>, the film including a helical chiral polymer that has optical activity and a weight-average molecular weight of from 50,000 to 1,000,000 and having a crystallinity of from 20% to 80% as obtained by a DSC method and a product of a standardized molecular orientation ratio MORc measured by a microwave molecular orientation meter based on a reference thickness of 50 $\mu$m and the crystallinity of from 25 to 700.

<9> The film according to any one of <4> to <8>, in which the helical chiral polymer is a polylactic acid-type polymer that has a main chain having a repeating unit represented by the following Formula (1):

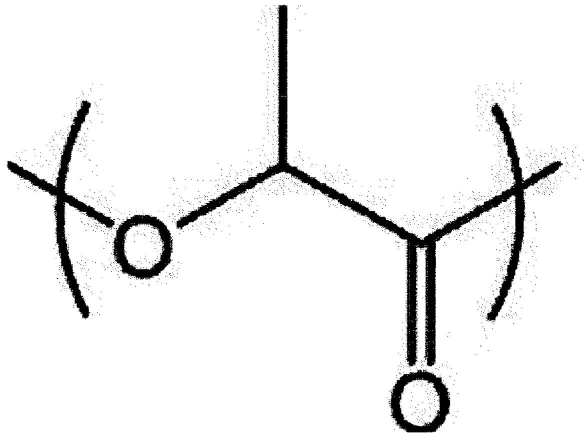

(1)

<10> A polymeric piezoelectric material that includes the film according to any one of <1> to <9>.

Effects of the Invention

The invention provides a film that exhibits reduced color non-uniformity and a polymeric piezoelectric material that includes the film.

DESCRIPTION OF EMBODIMENTS

A film of the invention has a molecular orientation, has an absolute difference ΔRe between the maximum and minimum retardations Re of 100 nm or less in a case in which the retardations Re are measured at every 0.8 mm along a measured length of 10 mm centered at the center of a principal plane of the film and at a wavelength of 550 nm, and has an average Re (ave) of the retardations Re in a range of from 700 nm to 900 nm or in a range of from 1250 nm to 1450 nm.

Through their research, the inventors of the invention found that films having a molecular orientation may exhibit visually noticeable color non-uniformity. This color non-uniformity tends to be visually noticed especially in a case in which observers view the films disposed between a pair of polarizing plates that are arranged in a crossed Nicols fashion or in a case in which observers view the films that include a polarizing plate on the side opposite to the viewing side through polarizing sunglasses.

Then, the inventors of the invention varied the average Re (ave) (hereinafter also simply referred to as "Re (ave)") while maintaining the absolute difference ΔRe (hereinafter also simply referred to as "ΔRe") at 100 nm or less and found that a film having a Re (ave) within any of the above two ranges (a range of from 700 nm to 900 nm or a range of from 1250 nm to 1450 nm) exhibits less visually noticeable color non-uniformity, thereby completing the invention.

Such a configuration allows for the film of the invention to exhibit reduced color non-uniformity.

In other words, a film having a Re (ave) outside of a range of from 700 nm to 900 nm and a range of from 1250 nm to 1450 nm exhibits visually noticeable color non-uniformity.

The range of from 700 nm to 900 nm is preferably in a range of from 750 nm to 850 nm and more preferably from 800 nm to 850 nm.

The range of from 1250 nm to 1450 nm is preferably in a range of from 1300 nm to 1400 nm and more preferably from 1300 nm to 1350 nm.

In the invention, a retardation Re (hereinafter also simply referred to as "Re") at a wavelength of 550 nm is represented by the following Formula a, as typically defined. For Re, see, for example, the description in Japanese Patent Application Laid-Open (JP-A) No. 2012-7110, if necessary.

$$\text{Formula a: } Re = (nx - ny) \times d$$

(In Formula a, nx is the index of refraction at a wavelength of 550 nm in the direction of the slow axis in a principal plane of a film, ny is the index of refraction at a wavelength of 550 nm in the direction of the fast axis in a principal plane of a film, and d is the thickness (nm) of a film.)

In the invention, the "measured length of 10 mm" is centered at the center of a principal plane of a film.

In the invention, the "measured length of 10 mm" is oriented in the direction in which the ΔRe as described

below is greatest.

In the invention, Re is measured at every 0.8 mm along such "measured length of 10 mm". Thus, Re is measured at 12 points. The absolute difference between the maximum and minimum Re of the 12 measurements is ΔRe, and the average of the 12 Re measurements is Re (ave).

The Re, the ΔRe, and the Re (ave) are measured using WPA-100 two-dimensional birefringence measurement system (from Photonic Lattice, Inc.).

In the invention, a principal plane of a film refers to a surface of the film, having the largest area. In other words, a principal plane of a film refers to one of the two planes other than the edge planes.

In the invention, examples of a method for controlling the Re (ave) of a film within the above ranges include, but not limited to, adjustment of the thickness of the film, the stretching ratio of the film, the crystallinity of the film, the type of an additive, and the amount of an additive added.

For example, the Re (ave) of a finally obtained film is suitably controlled by adjusting, for example, the thickness of a molded film (for example, pre-crystallized film), the crystallinity of a molded film (for example pre-crystallized film), stretching conditions (such as the stretching ratio) in a stretching step, and/or the crystallinity of the finally obtained film in a method for producing a film, the method including a step of obtaining the molded film (for example, pre-crystallized film) and a step of stretching (preferably uniaxially stretching) the resultant molded film, as described below.

In a case in which a polymer included in a film is positively birefringent (for example, in a case in which the polymer is a polylactic acid-type polymer as described below), addition of a negatively birefringent additive allows for decrease in the Re (ave). And in the same case, addition of a more positively birefringent additive than the positively birefringent polymer included in the film allows for increase in the Re (ave).

In a case in which a polymer included in a film is negatively birefringent, addition of a positively birefringent additive allows for decrease in the Re (ave). And in the same case, addition of a more negatively birefringent additive (having a higher absolute value) than the negatively birefringent polymer included in the film allows for increase in the Re (ave).

Examples of the additive include small organic molecules, polymers, and inorganic fillers.

The film of the invention has a ΔRe of 100 nm or less.

The film having a ΔRe of more than 100 nm would exhibit visually noticeable color non-uniformity.

The film preferably has a ΔRe of 80 nm or less, more preferably 70 nm or less, and particularly preferably 60 nm or less.

The film having a ΔRe of more than 20 nm (preferably more than 25 nm and more preferably 30 nm or more) has a more pronounced effect in reducing color non-uniformity, which is the effect of the invention.

Now, the effect will be described in more detail.

Films having a ΔRe of more than 20 nm tend to exhibit more visually noticeable color non-uniformity. However, in the invention, the color non-uniformity can be reduced by setting the Re (ave) in the above ranges, even if the ΔRe is more than 20 nm. The invention thus provide a particularly pronounced effect in reducing the color non-uniformity by setting the Re (ave) in the above ranges, in a case in which the ΔRe is more than 20 nm.

Through their research, the inventors of the invention also found that uniaxially-stretched (particularly, continuously uniaxially-stretched) films tend to have a higher ΔRe (for example, of more than 20 nm).

Thus, in a case in which the film of the invention is a uniaxially-stretched (particularly, continuously uniaxially-stretched) film, the film has a more pronounced effect in reducing the color non-uniformity by setting the Re (ave) in the above ranges.

As used herein, the term continuous uniaxial stretching refers to uniaxial stretching in which steps from pre-heating to uniaxial stretching are performed in a continuous manner, in a case in which a film is uniaxially stretched.

In the process, a film to be stretched may be unwound from a film roll or may be obtained by a melt extrusion technique or a casting technique.

As used herein, "in a continuous manner" refers that steps are performed in a roll-to-roll system.

In the invention, examples of a method for controlling the ΔRe of the film in the above range include, but not limited to, reduction of variation in molecular orientation and crystallinity of the film.

For example, the variation in molecular orientation and crystallinity of the finally obtained film is suitably reduced by, for example, adjusting pre-crystallization conditions for obtaining the pre-crystallized film, stretching conditions, and conditions for further crystallizing the pre-crystallized film in a method for stretching the pre-crystallized film (as detailed below), thereby controlling the ΔRe in the above range.

<Molecular Orientation Ratio MOR>

In the invention, the molecular orientation (the direction and the amount) is determined by measuring the molecular orientation ratio MOR (Molecular Orientation Ratio).

The molecular orientation ratio MOR indicates the degree of molecular orientation and is measured by a microwave measurement method as described below.

More specifically, a sample (film) is placed in a microwave resonant waveguide of a well-known microwave molecular orientation ratio measuring apparatus (also referred to as " microwave transmission-type molecular orientation meter ") with a plane of the sample (a principal plane of the film) oriented perpendicular to the direction of travel of the microwave.

Then, while the sample is continuously irradiated with the microwave oscillating unevenly in one direction, the sample is rotated from 0 to 360° in the plane perpendicular to the direction of travel of the microwave, and the intensity of the microwave passing through the sample can be measured to determine the molecular orientation ratio MOR.

The molecular orientation ratio MOR can be measured at a resonance frequency of about 4 GHz or about 12 GHz using a known microwave transmission-type molecular orientation meter such as MOA-2012A or MOA-6000 microwave molecular orientation meter from Oji Scientific Instruments Co., Ltd.

The molecular orientation ratio MOR can be controlled mainly by, for example, heat treatment conditions (heating temperature and heating period) before stretching a film to be uniaxially-stretched and stretching conditions (stretching temperature and stretching rate).

In the invention, in a case in which the film of the invention is a uniaxially stretched film, the molecular orientation is generally parallel to the uniaxial stretching direction.

In the invention, in a case in which the film of the invention is a biaxially stretched film, the molecular orientation is generally parallel to the major stretching direction.

From the viewpoint of reducing the color non-uniformity, the film of the invention preferably has a molecular orientation ratio MOR in a range of from 3.0 to 4.0 or in a range of from 5.5 to 6.5 as measured by a microwave transmission-type molecular orientation meter.

The molecular orientation ratio MOR and the Re (ave) may have the following relationship, in a case in which the film includes a helical chiral polymer having optical activity (particularly, a polylactic acid-type resin).

For example, the molecular orientation ratio MOR in a range of from 3.0 to 4.0 corresponds to the Re (ave) in a range of from 700 nm to 900 nm, while the molecular orientation ratio MOR in a range of from 5.5 to 6.5 corresponds to the Re (ave) in a range of from 1250 nm to 1450 nm.

In other words, the film of the invention more preferably has a Re (ave) in a range of from 700 nm to 900 nm and a molecular orientation ratio MOR in a range of from 3.0 to 4.0 or has a Re (ave) in a range of from 1250 nm to 1450 nm and a molecular orientation ratio MOR in a range of from 5.5 to 6.5.

The thickness of the film of the invention is not particularly limited and is preferably from 10 μm to 400 μm, more preferably from 20 μm to 200 μm, still more preferably from 20 μm to 100 μm, and particularly preferably from 20 μm to 80 μm, for example.

Particularly, the film of the invention more preferably has a Re (ave) in a range of from 700 nm to 900 nm and a thickness of from 20 μm to 50 μm (preferably from 25 μm to 45 μm) or has a Re (ave) in a range of from 1250 nm to 1450 nm and a thickness of from 40 μm to 80 μm (preferably from 45 μm to 75 μm and more preferably from 50 μm to 70 μm).

The molecular orientation ratio MOR can be measured at a resonance frequency of about 4 GHz or 12 GHz using a known molecular orientation meter such as MOA-2012A or MOA-6000 microwave molecular orientation meter from Oji Scientific Instruments Co., Ltd.

The molecular orientation ratio MOR can be controlled mainly by, for example, heat treatment conditions (heating temperature and heating period) before stretching a film to be uniaxially-stretched and stretching conditions (stretching temperature and stretching rate), as described below.

<Helical Chiral Polymer Having Optical Activity (Optically Active Polymer)>

The film of the invention preferably includes a helical chiral polymer having optical activity (hereinafter also referred to as "optically active polymer").

As used herein, the term helical chiral polymer having optical activity (optically active polymer) refers to a polymer having molecular optical activity and a helical molecular structure.

Examples of the optically active polymer can include polypeptides, cellulose derivatives, polylactic acid-type polymers, polypropylene oxides, and poly(β-hydroxybutyrate).

Examples of the polypeptides include poly(γ-benzyl glutamate) and poly(γ-methyl glutamate).

Examples of the cellulose derivatives include cellulose acetate and cyanoethyl cellulose.

The optically active polymer preferably has an optical purity of 95.00% ee or more, more preferably 96.00% ee or more, still more preferably 99.00% ee or more, and yet still more preferably 99.99% ee or more. The optically active polymer desirably has an optical purity of 100.00% ee.

By setting the optical purity of the optically active polymer in the above range, crystals of the polymer in the film are more densely packed. This can result in higher piezoelectricity (piezoelectric constant), for example in a case

in which the film is used as a piezoelectric film.

The optical purity of the optically active polymer is calculated with the following formula:

$$\text{Optical Purity (\% ee)} = 100 \times |\text{Amount of L-form} - \text{Amount of D-form}| / (\text{Amount of L-form} + \text{Amount of D-form})$$

Thus, the optical purity is defined as "the difference (absolute value) between the amount (% by mass) of the L-form and the amount (% by mass) of the D-form in the optically active polymer" divided by "the total of the amount (% by mass) of the L-form and the amount (% by mass) of the D-form in the optically active polymer" multiplied by "100".

As used herein, the amount (% by mass) of the L-form and the amount (% by mass) of the D-form in the optically active polymer are obtained using high performance liquid chromatography (HPLC).

From the viewpoint of increasing the optical purity (and of increasing the piezoelectricity in a case in which the film is used as a piezoelectric film), the optically active polymer preferably has a main chain having a repeating unit represented by the following Formula (1):

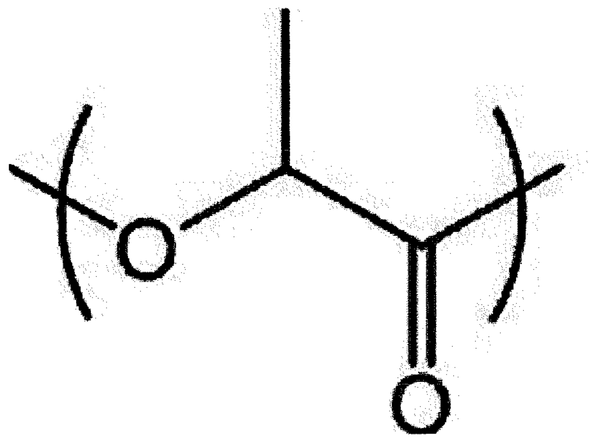

(1)

Examples of the polymer that has a main chain having a repeating unit represented by Formula (1) include polylactic acid-type polymers. Among them, polylactic acid is preferred, and homopolymers of L-lactic acid (PLLA) or homopolymers of D-lactic acid (PDLA) are most preferred. The polylactic acid-type polymers in the embodiment refer to "polymer compounds consisting of only repeating units derived from monomers selected from L-lactic acid or D-lactic acid)", "copolymers of L-lactic acid or D-lactic acid and a compound copolymerizable with the L-lactic acid or D-lactic acid", and mixtures thereof.

The "polylactic acid" is a long polymer formed by polymerization of lactic acid via ester bonds and is known to be able to be produced, for example, from lactide (a lactide method) or by heating lactic acid in a solvent under reduced pressure and polymerizing the lactic acid while removing water (a direct polymerization method). Examples of the "polylactic acid" include homopolymers of L-lactic acid, homopolymers of D-lactic acid, block copolymers that includes at least one of polymerized L-lactic acids or polymerized D-lactic acids, and graft copolymers that includes at least one of polymerized L-lactic acids or polymerized D-lactic acids.

Examples of the "compound copolymerizable with L-lactic acid or D-lactic acid" can include hydroxycarboxylic acids such as glycolic acid, dimethyl glycolic acid, 3-hydroxybutyric acid, 4-hydroxybutyric acid, 2-hydroxypropanoic acid, 3-hydroxypropanoic acid, 2-hydroxyvaleric acid, 3-hydroxyvaleric acid, 4-hydroxyvaleric acid, 5-hydroxyvaleric acid, 2-hydroxycaproic acid, 3-hydroxycaproic acid, 4-hydroxycaproic acid, 5-hydroxycaproic acid, 6-hydroxycaproic acid, 6-hydroxymethylcaproic acid, and mandelic acid; cyclic esters such as glycolide, $\beta$-methyl-$\delta$-valerolactone, $\gamma$-valerolactone, and $\varepsilon$-caprolactone; polycarboxylic acids such as oxalic acid, malonic acid, succinic acid, glutaric acid, adipic acid, pimelic acid, azelaic acid, sebacic acid, undecanedioic acid, dodecanedioic acid, and terephthalic acid and anhydrides thereof; polyhydric alcohols such as ethylene glycol, diethylene glycol, triethylene glycol, 1,2-propanediol, 1,3-propanediol, 1,3-butanediol, 1,4-butanediol, 2,3-butanediol, 1,5-pentanediol, 1,6-hexanediol, 1,9-nonanediol, 3-methyl-1,5-pentanediol, neopentyl glycol, tetramethylene glycol, and 1,4-hexanedimethanol; polysaccharides such as cellulose; and aminocarboxylic acids such as $\alpha$-amino acid.

Examples of the "copolymer of L-lactic acid or D-lactic acid and a compound copolymerizable with the L-lactic acid or D-lactic acid" include block copolymers or graft copolymers having a polylactic acid sequence that can form helical crystals.

The optically active polymer preferably has a concentration of a structure derived from the copolymerizable component of 20 mol% or less. For example, in a case in which the optically active polymer is a polylactic acid-type polymer, the optically active polymer preferably has a concentration of a structure derived from the compound copolymerizable with the lactic acid (copolymerizable component) of 20 mol% or less with respect to the total number of moles of a structure derived from lactic acid and the structure derived from the copolymerizable component.

The polylactic acid-type polymer can be produced by, for example, direct dehydration-condensation of lactic acid as described in JP-A No. S59-096123 and JP-A No. H07-033861 or ring-opening polymerization of lactide, which is the cyclic dimer of lactic acid, as described in, for example, US Patent No. 2,668,182 and US Patent No. 4,057,357.

To obtain the polymer having an optical purity of 95.00% ee or more by any of the methods as described above, for example, it is preferred to polymerize lactide having an increased optical purity of 95.00% ee or more due to crystallization, in a case in which the polylactic acid is produced by the lactide method.

The polylactic acid-type polymer may be a commercially available polylactic acid. Examples of the commercially available polylactic acid include PURASORB (PD and PL) from Purac Biomaterials, LACEA (H-100 and H-400) from Mitsui Chemicals, Inc., and Ingeo™biopolymers from NatureWorks LLC.

In a case in which the polylactic acid-type polymer is used as the optically active polymer, it is preferred to produce the polylactic acid-type polymer by the lactide method or the direct polymerization method to obtain the polylactic acid-type polymer having a weight-average molecular weight (Mw) of 50,000 or more.

In a case in which the film of the invention includes the optically active polymer, the film preferably includes the optically active polymer in an amount of 80% by mass or more.

The optically active polymer preferably has a weight-average molecular weight of from 50,000 to 1,000,000.

The optically active polymer having a weight-average molecular weight of 50,000 or more leads to further improved mechanical strength of the film. The optically active polymer preferably has a weight-average molecular weight of 100,000 or more and more preferably 150,000 or more.

Meanwhile, the optically active polymer having a weight-average molecular weight of 1,000,000 or less would be difficult to mold (for example, extrusion-mold) into a film. The optically active polymer preferably has a weight-average molecular weight of 800,000 or less and more preferably 300,000 or less.

From the viewpoint of the strength of the film, the optically active polymer preferably has a molecular weight distribution (Mw/Mn) of from 1.1 to 5, more preferably from 1.2 to 4, and still more preferably from 1.4 to 3.

The weight-average molecular weight Mw and the molecular weight distribution (Mw/Mn) of the optically active polymer are measured using the following gel permeation chromatography (GPC) method and equipment.

- GPC System -

GPC-100 from Waters Corp.

- Column -

SHODEX LF-804 from Showa Denko K.K.

- Preparation of Sample -

The optically active polymer is dissolved in a solvent (for example, chloroform) at a concentration of 1 mg/ml at 40°C to prepare a sample solution.

- Measurement Conditions -

0.1 ml of the sample solution is injected into the column with chloroform as a solvent at a temperature of 40°C and a flow rate of 1 ml/min.

The concentration of the sample in the sample solution separated in the column is measured using a differential refractometer. The universal calibration curve is created using polystyrene standards, and the weight-average molecular weight (Mw) and the molecular weight distribution (Mw/Mn) of the optically active polymer are calculated.

<Standardized Molecular Orientation Ratio MORc>

The standardized molecular orientation ratio MORc of the film of the invention can also be determined with the following formula.

As used herein, the standardized molecular orientation ratio MORc refers to MOR based on a reference thickness tc of 50 μm.

$$MORc = (tc/t) \times (MOR - 1) + 1$$

(tc: reference thickness for correction, t: sample thickness, MOR: molecular orientation ratio)

The standardized molecular orientation ratio MORc can be measured at a resonance frequency of about 4 GHz or about 12 GHz using a known molecular orientation meter such as MOA-2012A or MOA-6000 microwave molecular orientation meter from Oji Scientific Instruments Co., Ltd.

The standardized molecular orientation ratio MORc can be controlled mainly by, for example, heat treatment conditions (heating temperature and heating period) before stretching a film to be uniaxially-stretched and stretching conditions (stretching temperature and stretching rate), as described below.

The range of the standardized molecular orientation ratio MORc of the film of the invention is not particularly limited, and it is preferred to control the MORc so that the film has a molecular orientation ratio MOR in a range of from 3.0 to 4.0 or in a range of from 5.5 to 6.5.

From the viewpoint of allowing many polymer chains to be aligned with the stretching direction and increasing the rate of production of oriented crystals, the standardized molecular orientation ratio MORc is preferably from 3.5 to 15.0, more preferably from 4.0 to 15.0, still more preferably from 6.0 to 10.0, and particularly preferably from 7.0 to 10.0.

The film of the invention having a standardized molecular orientation ratio MORc of from 3.5 to 15.0 may exhibit higher piezoelectricity, for example in a case in which the film is used as a piezoelectric film.

<Crystallinity>

The film in the invention preferably has a crystallinity of from 20% to 80%.

As used herein, the crystallinity can be determined by a DSC method.

The film preferably has a crystallinity of from 25% to 70% and more preferably from 30% to 50%.

The film having a crystallinity of from 20% to 80% has a balanced combination of mechanical strength and transparency of the film. Thus, when the film is stretched, the film is less likely to whiten and break and thus is readily produced.

<Product of Standardized Molecular Orientation Ratio MORc and Crystallinity>

The film of the invention preferably has a product of a standardized molecular orientation ratio MORc and a crystallinity of from 25 to 700, more preferably from 40 to 700, still more preferably from 75 to 680, yet still more preferably from 90 to 660, yet still more preferably from 125 to 650, and yet still more preferably from 180 to 350.

The film having a product in a range of from 25 to 700 maintains suitable transparency and dimensional stability.

The film also maintains suitable piezoelectricity in a case in which the film of the invention is used as a piezoelectric film.

From the viewpoint of productivity of oriented crystals, mechanical strength, dimensional stability, and transparency, the film of the invention preferably includes a helical chiral polymer having a weight-average molecular weight of from 50,000 to 1,000,000 and optical activity and preferably has a crystallinity of from 20% to 80% as obtained by a DSC method and a product of a standardized molecular orientation ratio MORc as measured by a microwave molecular orientation meter based on a reference thickness of 50 μm and a crystallinity of from 25 to 700. In this aspect, the film has a somewhat high piezoelectricity in a case in which the film of the invention is used as a piezoelectric film.

<Internal Haze>

The transparency of the film of the invention can be evaluated by, for example, visual observation and measurement of haze.

The film of the invention preferably has an internal haze as determined using visible light (hereinafter also simply referred to as "internal haze") of 50% or less, more preferably 20% or less, still more preferably 15% or less, yet still more preferably 10% or less, particularly preferably 5% or less, and still even more preferably 2% or less.

Although the film of the invention having a lower internal haze is better, in a case in which the film of the invention is used as a piezoelectric film, the film preferably has an internal haze of from 0.01% to 15%, more preferably from 0.01% to 10%, and particularly preferably from 0.1% to 5%, from the viewpoint of the balance with, for example, piezoelectric constant.

In the invention, the term "internal haze" refers to the haze excluding any film surface contribution.

As used herein, the "internal haze" is measured at 25°C for a film in accordance with JIS-K7105.

More particularly, the internal haze in the invention (hereinafter also referred to as "internal haze H1") is measured

as described below.

First, a cell that has a optical path length of 10 mm and that is filled with silicone oil is measured for the haze in the direction of the optical path length (hereinafter also referred to as "haze H2"). Then, the film of the invention is immersed in the silicone oil in the cell with the normal direction of the film oriented parallel to the direction of the optical path length of the cell. The cell with the film immersed therein is measured for the haze in the direction of the optical path length (hereinafter also referred to as "haze H3"). The haze H2 and the haze H3 are measured at 25°C in accordance with JIS-K7105.

Based on the measured haze H2 and the measured haze H3, the internal haze H1 is determined with the following formula:

$$\text{Internal Haze (H1)} = \text{Haze (H3)} - \text{Haze (H2)}$$

The haze H2 and the haze H3 can be measured using, for example, a haze meter (TC-HIII DPK from Tokyo Denshoku Co, Ltd.).

An example of the silicone oil that can be used is "SHIN-ETSU SILICONE™ KF-96-100CS" from Shin-Etsu Chemical Co., Ltd.

<Piezoelectric Constant>

The film of the invention preferably has a piezoelectric constant $d_{14}$ of 1 pC/N or more as measured at 25°C using a stress-charge method. This can result in higher piezoelectricity in a case in which the film of the invention is used as a piezoelectric film.

The "piezoelectric constant $d_{14}$" is an element of the tensor of piezoelectric modulus and is determined from polarization arising along the direction of a shear stress applied in the direction of the stretch axis of the stretched material. Specifically, $d_{14}$ is defined as the charge density generated per unit shear stress. A higher value of the piezoelectric constant $d_{14}$ indicates higher piezoelectricity. In the present application, when we simply refer to "piezoelectric constant", it means the "piezoelectric constant $d_{14}$" as measured using a stress-charge method.

A complex piezoelectric modulus $d_{14}$ is calculated as "$d_{14} = d_{14}' - id_{14}''$", in which "$d_{14}'$" and "$id_{14}''$" are obtained using "RHEOLOGRAPH-SOLID S-1" from Toyo Seiki Seisaku-sho, Ltd. "$d_{14}$ represents the real part of the complex piezoelectric modulus, while "$id_{14}''$" represents the imaginary part of the complex piezoelectric modulus. $d_{14}'$ (the real part of the complex piezoelectric modulus) corresponds to the piezoelectric constant $d_{14}$ in the embodiment. A higher value of the real part of the complex piezoelectric modulus indicates higher piezoelectricity.

Now, an example of a method for measuring the piezoelectric constant $d_{14}$ using a stress-charge method will be described.

First, the film of the invention is cut into a rectangular specimen having a length of 150 mm in the direction of 45° with respect to the stretching direction (for example, the MD direction) and a width of 50 mm in the direction perpendicular to the above 45° direction. Then, the specimen is placed on the test platform of SIP-600 from Showa Shinku Co., Ltd., and A1 is deposited on one surface of the specimen at an A1 deposition thickness of about 50 nm. Then, A1 is deposited on the other surface the specimen in the same manner to provide the specimen having an A1 conductive layer on the both surfaces.

The 150 mm x 50 mm specimen (film) having an A1 conductive layer on the both surfaces is cut into a rectangular film having a length of 120 mm in the direction of 45° with respect to the stretching direction (for example, the MD direction) and a width of 10 mm in the direction perpendicular to the above 45° direction, to cut out a piece of rectangular film in a size of 120 mm×10 mm.. The film is used as a sample for measurement of the piezoelectric constant.

The resultant sample is tightly clamped into a tensile tester (TENSILON RTG-1250 from AND Co., Ltd) with a distance between chucks of 70 mm. Then, a force varying in the range of from 4N to 9N is periodically applied at a crosshead speed of 5 mm/min. To measure the amount of charge generated in the sample in response to the applied force, a capacitor having a capacitance of Qm (F) is connected in parallel with the sample, and the voltage V between the terminals of the capacitor Cm (95 nF) is measured via a buffer amplifier. The amount of charge stored on each plate Q (C) is calculated as the product of the capacitance Cm of capacitor and the voltage between the terminals Vm. The piezoelectric constant $d_{14}$ is calculated with the following formula:

$$d_{14} = (2 \times t)/L \times Cm \cdot \Delta Vm/\Delta F$$

t: sample thickness (m)

L: distance between chucks (m)
Cm: capacitance of capacitor connected in parallel (F)
$\Delta Vm/\Delta F$: ratio of change in voltage between the terminals to change in force

A higher piezoelectric constant leads to a larger displacement of the material in response to voltage applied to the film and to a higher voltage generated in response to force applied to the film, which is beneficial.

Specifically, the piezoelectric constant $d_{14}$ as measured at 25°C using the stress-charge method is preferably 1 pC/N or more, more preferably 4 pC/N or more, still more preferably 6 pC/N or more, and yet still more preferably 8 pC/N or more. Although the upper limit of the piezoelectric constant is not critical, the piezoelectric constant may preferably be 50 pC/N or less and more preferably 30 pC/N or less, from the viewpoint of the balance with transparency.

From the viewpoint of providing a more effective combination of transparency and piezoelectricity, the film of the invention particularly preferably has an internal haze of 50% or less as determined using visible light and a piezoelectric constant $d_{14}$ of 1 pC/N or more as measured at 25°C using the stress-charge method.

<Stabilizer>

The film of the invention preferably includes, as a stabilizer, a compound having one or more functional groups selected from the group consisting of a carbodiimide group, an epoxy group, and an isocyanate group and having a weight-average molecular weight of from 200 to 60,000.

This can suppress hydrolysis of the optically active polymer and improve wet heat resistance of the resultant film.

For the stabilizer, you can see the paragraphs 0039-0055 of WO2013/054918, if necessary.

<Other Components>

The film of the invention may include other components including known resins such as polyvinylidene fluoride, polyethylene resin, and polystyrene resin, inorganic fillers such as silica, hydroxyapatite, and montmorillonite, known crystal nucleating agents such as phthalocyanine, to the extent that the components do not reduce the benefits of the invention.

In a case in which the film of the invention includes the optically active polymer, the film preferably includes a component other than the optically active polymer in an amount of 20% by mass or less and more preferably 10% by mass or less with respect to the total mass of the film.

- Inorganic Filler -

For example, to obtain a transparent film having reduced voids such as bubbles as the film of the invention, an inorganic filler such as hydroxyapatite may be nano-dispersed in the film. It is to be noted that to nano-disperse the inorganic filler, a large amount of energy is needed to de-agglomerate the agglomerates and that in a case in which the filler cannot be nano-dispersed, the film may have reduced transparency. In a case in which the film of the invention includes an inorganic filler, the film preferably include the inorganic filler in an amount of less than 1% by mass with respect to the total mass of the film.

- Crystallization Accelerator (Crystal Nucleating Agents) -

Any crystallization accelerator may be used as long as the accelerator has the effect of promoting crystallization and is desirably selected from the substances having a crystal structure with interplanar spacing similar to the spacing in the crystal lattice of the optically active polymer. A substance with more similar interplanar spacing has a greater effect as the nucleating agent.

For example, in a case in which the optically active polymer is a polylactic acid-type polymer, examples of the crystallization accelerator include organic materials such as zinc phenylsulfonate, melamine polyphosphate, melamine cyanurate, zinc phenylphosphonate, calcium phenylphosphonate, and magnesium phenylphosphonate, and inorganic materials such as talc and clay. Among them, zinc phenylphosphonate is preferred, as it has an interplanar spacing most similar to the interplanar spacing in polylactic acid and is highly effective in accelerating crystallization. The crystallization accelerator may be a commercially available product. More particularly, examples of the commercially available product include ECOPROMOTE zinc phenylphosphonate (from Nissan Chemical Industries, Ltd.).

The film includes a crystal nucleating agent typically in an amount of from 0.01 parts by weight to 1.0 parts by weight, preferably from 0.01 parts by weight to 0.5 parts by weight, and, from the viewpoint of better accelerating crystallization and maintaining biomass ratio, particularly preferably from 0.02 parts by weight to 0.2 parts by weight based on 100 parts by weight of the optically active polymer. The film including a crystal nucleating agent in an amount

of less than 0.01 parts by weight would not be sufficiently effective in accelerating crystallization, while the film including a crystal nucleating agent in an amount of more than 1.0 parts by weight would tend to have reduced transparency, as it would be difficult to control the rate of crystallization.

<Applications of Film>

The film of the invention can be suitably used as a piezoelectric film.

In addition to a piezoelectric film, the film of the invention can be used as, for example, optical films for, for example, display devices.

The film of the invention can be used as, for example, a piezoelectric film for various articles such as speaker systems, headphones, touch panels, remote controllers, microphones, underwater microphones, ultrasonic transducers, ultrasonic meters, piezoelectric vibrators, mechanical filters, piezoelectric transformers, delay devices, sensors, acceleration sensors, impact sensors, vibration sensors, pressure-sensitive sensors, tactile sensors, electric field sensors, sound pressure sensors, displays, fans, pumps, variable-focus mirrors, sound insulation materials, sound proof materials, keyboards, acoustic equipment, information processing equipment, measurement equipment, and medical equipment.

Preferably, the film of the invention is used as a piezoelectric element having at least two principal planes provided with electrodes.

It is only necessary that electrodes are provided on at least two planes of the film. Examples of the electrodes include, but not limited to, ITO, ZnO, IZO®, and conductive polymers.

The film of the invention may also be used as part of a laminated piezoelectric element.

Examples of the laminated piezoelectric element include elements formed by disposing units of an electrode and a piezoelectric film on top of one another in layers and covering, with an electrode, a principal plane of the piezoelectric film, not covered with an electrode. More particularly, in a case in which two of the units are disposed on top of one another, the laminated piezoelectric element is formed by disposing an electrode, a piezoelectric film, an electrode, a piezoelectric film, an electrode on top of one another, in this order. It is only necessary that plural piezoelectric films used for the laminated piezoelectric element include at least one of the film of the invention, and the other piezoelectric films need not be the film of the invention.

In a case in which a laminated piezoelectric element includes a plural number of the films of the invention, one of the films of the invention needs to include an optically active polymer in the L optical configuration, and the others of the films of the invention may include an optically active polymer in the L or D optical configuration. The arrangement of the films of the invention may be adjusted as appropriate for each application of the piezoelectric element.

For example, in a case in which a first film including an optically active polymer in the L optical configuration as a major component is disposed on a second film including an optically active polymer in the L optical configuration as a major component via an electrode, the displacement directions of the first film and the second film can be aligned by allowing the direction in which the first film is uniaxially stretched (main stretching-direction) to cross, preferably perpendicularly, the direction in which the second film is uniaxially stretched (main stretching-direction). Such arrangement is preferred because the laminated piezoelectric element can have increased piezoelectricity as a whole.

In a case in which a first film including an optically active polymer in the L optical configuration as a major component is disposed on a second film including an optically active polymer in the D optical configuration as a major component via an electrode, the displacement directions of the first film and the second film can be aligned by allowing the direction in which the first film is uniaxially stretched (main stretching-direction) to be oriented approximately parallel to the direction in which the second film is uniaxially stretched (main stretching-direction). Such arrangement is preferred because the laminated piezoelectric element can have increased piezoelectricity as a whole.

Especially in a case in which a principal plane of the film is provided with an electrode, the electrode preferably has a transparency. When we refer that the electrode has a transparency, we particularly mean that the electrode has an internal haze of 20% or less (a total light transmittance of 80% or more).

The piezoelectric elements using the film of the invention can be used in various piezoelectric devices such as speaker systems and touch panels, as described above. Especially, the piezoelectric elements provided with an electrode having a transparency is suitably used in, for example, speaker systems, touch panels, and actuators.

<Production of Film>

As described above, the film of the invention is preferably a stretched (preferably uniaxially stretched) film.

A suitable method for producing the film of the invention includes, for example, a step of molding a composition including a polymer (for example, the optically active polymer as described above, hereinafter the same) or the polymer alone into a film by, for example, extrusion molding to obtain a molded article (for example, a pre-crystallized film as described below) and a step of stretching (preferably uniaxially stretching) the resultant molded article.

In such method, the Re (ave) of the finally obtained film can be controlled within the above ranges by, for

example, adjusting the thickness of the molded article before stretching and the stretching conditions (such as the stretching ratio).

Examples of a combination of the thickness of the molded article before stretching and the stretching ratio include a first combination of a thickness of the molded article of from 100 μm to 180 μm (preferably from 120 μm to 160 μm and more preferably from 120 μm to 140 μm) and a stretching ratio of from 3 times to 4 times, or a second combination of a thickness of the molded article of from 190 μm to 300 μm (preferably from 200 μm to 270 μm and more preferably from 200 μm to 230μm) and a stretching ratio of from 3 times to 4 times.

The first combination allows for control of the Re (ave) within the range of from 700 nm to 900 nm.

The second combination allows for control of the Re (ave) within the range of from 1250 nm to 1450 nm.

The step of obtaining the molded article and the step of stretching the article may be performed in a continuous manner (continuous uniaxial stretching) or a batch manner (batch uniaxial stretching).

It is to be noted that in a case in which the steps are performed in a continuous manner, the film tends to have a large ΔRe, as described above, and thus that control of the Re (ave) within the above ranges allows for the film to have a significantly pronounced effect in reducing the color non-uniformity in a case in which the steps are performed in a continuous manner.

The same principle applies to steps in methods A and B for producing the film as described below.

Now, preferred methods (methods A and B) for producing the film that includes at least the optically active polymer will be described.

- Method A -

The method A includes a first step of obtaining a pre-crystallized film (also referred to as "original crystallized film") that includes the optically active polymer (and optionally, other components such as a stabilizer) and a second step of stretching the pre-crystallized film mainly in a uniaxial direction.

In the method A, the raw material of the film can be obtained by melt-kneading an optically active polymer such as a polylactic acid-type polymer as described above (and optionally, other components such as a stabilizer including a carbodiimide compound). More particularly, it is suitable to melt-knead the optically active polymer and other optional components at a mixer speed of from 30 rpm to 70 rpm and a temperature of from 180°C to 250°C for a period of from 5 minutes to 20 minutes using a melt-kneading machine (LABO PLASTOMILL from Toyo Seiki Seisaku-sho, Ltd.).

This can result in, for example, a blend of the optically active polymer and a stabilizer, a blend of plural helical chiral polymers, or a blend of a helical chiral polymer and other components such as an inorganic filler.

Generally, increase of force that is applied to the film during stretching promotes orientation of the optically active polymer, while the increased force promotes crystallization and thus increase of the crystal size, which tends to increase the haze. And increase in internal stress tends to increase the rate of dimensional change. In contrast, simple application of force to the film causes crystals that are not oriented, such as spherocrystals, to form.

Thus, it is preferred to efficiently form oriented crystals of a fine size to the extent that the film does not have a large haze, in order to promote orientation of the optically active polymer (i.e., to achieve a high molecular orientation ratio MOR (or a high standardized molecular orientation ratio MORc)) and to form a film having a low haze and a low rate of dimensional change.

In the method A, for example, a region in the film is pre-crystallized before stretching the film to form fine crystals, and then the film is stretched. This allows for efficient application of force, during stretching, to polymer portions having a low crystallinity between the fine crystals and thus for efficient orientation of the helical chiral polymer in a main stretching direction. Specifically, oriented fine crystals are generated in the polymer portions having a low crystallinity between the fine crystals. At the same time, the spherocrystals generated by the pre-crystallization are disrupted, and the crystal lamellae that constituting the spherocrystals are oriented in the stretching direction in a row connected by tie-molecular chains, thereby achieving a desired molecular orientation ratio MOR (or a desired standardized molecular orientation ratio MORc).

This can promote orientation of the optically active polymer and provide a sheet having a low haze and a low rate of dimensional change.

For control of the MOR (or MORc), it is important to adjust the crystallinity of the original crystallized film by, for example, the heating period and the heating temperature in the first step and to adjust the stretching rate and the stretching temperature in the second step. As described above, a helical chiral polymer has molecular optical activity. An amorphous film that includes a helical chiral polymer and a carbodilite compound may be a commercial available film or may be produced by a know method for molding a film such as extrusion molding. The amorphous sheet may be single-layered or multi-layered.

-- First Step (Pre-Crystallization Step) --

The first step is to obtain the pre-crystallized film that includes the optically active polymer (and optionally, other components such as a stabilizer).
In the step, the pre-crystallized film can be obtained by heating raw materials including the optically active polymer (and optionally, other components such as a stabilizer) to a temperature higher than the glass transition temperature of the optically active polymer, molding (for example, extrusion-molding) the heated material into a film, and rapidly cooling the extruded film at a caster.
The pre-crystallized film can also be obtained by heating the amorphous film including the optically active polymer (and optionally, other components such as a stabilizer) to crystallize the film.
And 1) The pre-crystallized film, which is previously crystallized, may be fed for the stretching step (second step) as described below, be placed on a stretching device, and be stretched (off-line heating), or 2) the amorphous film, which is not crystallized by heating, may be placed on a stretching device, be pre-crystallized by heating the film on the stretching device, then be continuously fed for the stretching step (second step), and be stretched (in-line heating).
Although the amorphous film may be heated at any heating temperature T for the pre-crystallization, it is preferred to set the heating temperature T so that the temperature satisfies a relationship with the glass transition temperature Tg of the optically active polymer as represented by the following formula and that the crystallinity is from 3% to 70% to increase, for example, the MOR (or MORc) and the transparency of the film produced by the method A.

$$Tg - 40^{\circ}C \leq T \leq Tg + 40^{\circ}C$$

(Tg represents the glass transition temperature of the optically active polymer.)
As used herein, the glass transition temperature (Tg) of the optically active polymer is obtained as the inflection point in a melting endotherm curve obtained by heating the sample (for example, the optically active polymer) at a temperature increase rate of 10°C/min using a differential scanning calorimeter (DSC).
The period for which the amorphous film is heated for pre-crystallization or the period for which the raw material is heated for crystallization in a case in which the raw material is extrusion-molded into a film may be adjusted so that the film has a desired crystallinity and that the film after stretching (after the second step) preferably has a product of a standardized molecular orientation ratio MORc and a crystallinity of from 25 to 700, more preferably from 40 to 700, still more preferably from 125 to 650, and yet still more preferably from 250 to 350. A longer heating period leads to a higher crystallinity after stretching and a higher MOR (or MORc) after stretching. A shorter heating period tends to lead to a lower crystallinity after stretching and a lower MOR (or MORc) after stretching.
The pre-crystallized film before stretching having a higher crystallinity is harder and thus is subject to higher stretching stress. Thus, portions having a relatively low crystallinity in the film also have a higher orientation, and then the film after stretching has a higher MOR (or MORc). In contrast, the pre-crystallized film before stretching having a lower crystallinity is softer and thus is less subject to stretching stress. Thus, it is believed that portions having a relatively low crystallinity in the film also have a lower orientation, and then the film after stretching has a lower MOR (or MORc).
The heating period depends on the heating temperature, the thickness of the film, the molecular weight of the polymer constituting the film, the type and the amount of, for example, an additive. The actual period for which the film is heated for crystallization corresponds to the total of a pre-heating period and a heating period in the pre-crystallization step before the pre-heating, in a case in which the film is pre-heated at the crystallization temperature of the amorphous film in a pre-heating step that may be performed before the stretching step (second step) as described below.
The period for which the amorphous film is heated or the period for which the raw material is heated for crystallization in a case in which the raw material is extrusion-molded into a film is typically from 5 seconds to 60 minutes and may be from a minute to 30 minutes from the viewpoint of stability of the production conditions. For example, in a case in which an amorphous film that includes a polylactic acid-type polymer as the optically active polymer is pre-crystallized, the film is preferably heated at a temperature of from 20°C to 170°C for a period of 5 seconds to 60 minutes or may be heated for a period of a minute to 30 minutes.
For efficiently obtaining a stretched film having a high MOR (or MORc), a high transparency, and a high dimensional stability, it is important to adjust the crystallinity of the pre-crystallized film before stretching. Reasons for why the MOR (or MORc) and the dimensional stability are increased by stretching are believed to be that the stretching stress is concentrated on relatively high crystalline portions in the pre-crystallized film that are assumed to be in spherocrystalline form, and the portions are oriented while the spherocrystals are disrupted, and that the stretching stress is also applied to relatively low crystalline portions via the spherocrystal and thus the portions are caused to be oriented.
The conditions are set so that the film after stretching or after annealing in a case in which the film is annealed as described below has a crystallinity of from 20% to 80% and preferably from 40% to 70%. Thus, the conditions are

set so that the pre-crystallized film immediately before stretching has a crystallinity of from 3% to 70%, preferably from 10% to 60%, and more preferably from 15% to 50%.

The crystallinity of the pre-crystallized film may be measured in the same manner as for the crystallinity after stretching of the film in the embodiment.

Although the thickness of the pre-crystallized film mainly depends on the film thickness desired to be obtained by the stretching stress of the second step and the stretching ratio, the pre-crystallized film preferably has a thickness of from 50 μm to 1000 μm and more preferably of from about 100 μm to about 800 μm.

From the viewpoint of readily controlling the Re (ave) within the above ranges, the pre-crystallized film preferably has a combination of a thickness and a stretching ratio as described above.

-- Second Step (Stretching Step) --

In the stretching step, which is the second step of the method A, any stretching method can be used, such as uniaxial stretching, biaxial stretching, or solid phase stretching as described below.

The second step can suitably provide a film having a principal plane with a large area, as well as having a molecular orientation.

It is assumed that stretching of the pre-crystallized film mainly in one direction allows for orientation in one direction and high-density alignment of molecular chains of the optically active polymer (for example, a polylactic acid-type polymer) included in the pre-crystallized film.

In a case in which the pre-crystallized film is stretched only by tensile force as in uniaxial stretching or biaxial stretching, the pre-crystallized film is preferably stretched at a temperature in a range of from about 10°C higher to about 20°C higher than the glass transition temperature of the pre-crystallized film.

The film is preferably stretched at a stretching ratio in a range from 3 times to 30 times and more preferably from 3 times to 15 times.

From the viewpoint of readily controlling the Re (ave) within the above ranges, the pre-crystallized film preferably has a combination of a thickness and a stretching ratio as described above.

In a case in which the pre-crystallized film is stretched, the film may be pre-heated immediately before stretching, for ease of stretching. Generally, the purpose of the pre-heating is to soften the film before stretching, for ease of stretching, and thus the film before stretching is typically heated under the conditions that do not cause the film to be crystallized and hardened. It is to be noted that in the method A, the film is pre-crystallized before stretching, the pre-heating may be performed in the pre-crystallization step. More particularly, the pre-heating can be performed in the pre-crystallization step by heating the film at a temperature higher than a typical pre-heating temperature or for a longer period for the adaptation to the heating temperature and the heating period in the pre-crystallization step as described above.

--Annealing Step --

From the viewpoint of improving the MOR (or MORc), the film is preferably subjected to certain heat treatment (hereinafter also referred to as "annealing") after stretching (after the second step). In a case in which the film is crystallized mainly by annealing, the pre-crystallized step as described above may be omitted.

In the annealing step, the film is preferably heated at a temperature of from about 80°C to about 160°C and more preferably from 100°C to 155°C.

In the annealing step, the film may be heated in a single stage or may be heated at different temperatures in multi-stages.

Examples of a method for heating the film in the annealing step include, but not limited to, direct heating with a hot-air heater or an infrared heater and heating by immersion of the film in heated liquid such as heated silicone oil.

In a case in which the film deforms upon linear expansion in the annealing steps, it is difficult to obtain a flat film for practical use. Thus preferably, the film is heated while a certain tensile stress (for example, of from 0.01 MPa to 100 MPa) is applied to prevent slack in the film.

In the annealing step, the film is preferably heated for a period in a range from a second to 60 minutes, more preferably from a second to 300 seconds, and still more preferably from a second to 60 seconds. In a case in which the film is annealed for a period of more than 60 minutes, spherocrystals may be grown from the molecular chains in the amorphous portions at a temperature higher than the glass transition temperature of the film, thereby reducing orientation. This may result in reduced piezoelectricity and reduced transparency.

The film annealed as described above is preferably rapidly cooled after annealing. In the annealing step, the term "rapid cool" refers to cooling of the annealed film immediately after annealing by, for example, immersing the film in ice water to cool the film to a temperature at least equal to or lower than the glass transition temperature Tg, provided that no other treatments are performed between the annealing and, for example, the immersion in ice water.

Examples of a method for rapidly cooling the film include immersion of the annealed film in a refrigerant such as water, ice water, ethanol, ethanol or methanol with dryice, and liquid nitrogen and generation of latent heat of evaporation by spraying liquid having a low vapor pressure. To continuously cool the film, the film can be rapidly cooled by contacting the film with a metal roll that is controlled at a temperature equal to or lower than the glass transition temperature Tg of the film. The film may be cooled only once or two times or more. And cycles of annealing and cooling may be alternated.

- Method B -

In a case in which the film includes at least the optically active polymer, examples of a preferred method for producing the film include the method B, in addition to the method A as described above.
The method B includes a step of stretching a sheet that includes the optically active polymer (and optionally, other components such as a stabilizer) mainly in a uniaxial direction and a step of annealing the film, in this order. The stretching step and the annealing step can be the same as those in the method A.
In the method B, a pre-crystallized step as in the method A may not be performed.
A polymeric piezoelectric material that includes the film of the invention is also included in the scope of the invention. The polymeric piezoelectric material of the invention can be produced by a method similar to that for the film of the invention.

Examples

Now, the embodiments of the invention will be described more specifically with reference to examples, but the invention is not limited to the examples without departing from the spirit of the invention.

[Example 1]

<Production of Film>

A film of Example 1 was produced by continuous uniaxial stretching in which steps are performed continuously. The details are described below.
Polylactic acid (PLA) from NatureWorks LLC (trade name: Ingeo™biopolymers, model number: 4032D, weight-average molecular weight Mw: 200,000), which is an optically active polymer, was prepared as a raw material.
The prepared material was fed into a hopper of an extruder. The material was extruded from a T die, while the material is heated to a temperature of from 220°C to 230°C. The extrudate was contacted with a casting roll at 55°C for 0.5 minutes to give a pre-crystallized film having a thickness of 220 μm (pre-crystallization step). The crystallinity of the pre-crystallized sheet was measured to be 5.6%.
While the resultant pre-crystallized film is heated to 72.5°C, the film was uniaxially stretched at a stretching rate of 1650 mm/min and a stretching rate of 3.6 times in the MD direction in a roll-to-roll system (continuous uniaxial stretching) to give a stretched film (stretching step).
In a roll-to-roll system, the resultant stretched film was heated by sequentially passing the film over a heated roll at 100°C over a period of 5 seconds, a heated roll at 130°C over a period of 10 seconds, and then a heated roll at 145°C over a period of 10 seconds. Then the film was cooled by passing the film over a cooling roll at 60°C to give a film. (The above procedures are the annealing step).
The resultant film had a thickness of 60 μm.
In Example 1, the molecular orientation was parallel to the uniaxial stretching direction. (The angle between the molecular orientation and the uniaxial stretching direction was 0°.)

<Mw, Mw/Mn, Optical Purity, and Chirality of Optically Active Polymer>

The Mw, the Mw/Mn, the optical purity, and the chirality of the optically active polymer (PLA) included in the above film were measured in the following manners.
The results are illustrated in Table 1 below.

(Optical Purity and Chirality)

1.0 g of the sample (the film obtained as described above) was weighed into a 50 mL Erlenmeyer flask, and 2.5 mL of IPA (isopropyl alcohol) and 5 mL of a solution of sodium hydroxide at 5.0 mol/L were added. Then, the Erlenmeyer flask containing the sample solution was placed in a water bath at a temperature of 40°C and stirred for

about 5 hours until complete hydrolysis of the polylactic acid.

After the sample solution was cooled to room temperature, 20 mL of a solution of hydrochloric acid at 1.0 mol/L was added for neutralization. The Erlenmeyer flask was stoppered and stirred vigorously. 1.0 mL of the sample solution was transferred to a 25 mL volumetric flask and diluted to 25 mL with mobile phase to prepare an HPLC sample solution 1. Then, 5 μL of the HPLC sample solution 1 was injected into an HPLC system. Peak areas are determined for D/L-polylactic acid in the following HPLC conditions, and the amount of the L-form and the amount of the D-form were calculated. From the calculation, the optical purity and the chirality of the optically active polymer included in the film were determined.

-HPLC Measurement Conditions -

· Column

SUMICHIRAL OA5000 chiral separation column from Sumika Chemical Analysis Service, Ltd.

· Measurement Device

Liquid chromatograph from JASCO Corp.

· Column Temperature

25°C

· Mobile Phase

1.0 mM copper (II) sulfate buffer/IPA = 98/2 (V/V)

Copper (II) sulfate /IPA/water = 156.4 mg/20 mL/980 mL

· Flow Rate of Mobile Phase

1.0 ml/min

· Detector

Ultra-violet detector (UV 254 nm)

(Weight-Average Molecular Weight (Mw) and Molecular Weight Distribution

(Mw/Mn))

The following gel permeation chromatograph (GPC) equipment and method were used to determine the molecular weight distribution (Mw/Mn) of the optically active polymer included in the film obtained above.

- GPC Measurement Method -

· Measurement Device

GPC-100 from Waters Corp.

· Column

SHODEX LF-804 from Showa Denko K.K.

· Preparation of Sample

The film obtained above was dissolved in a solvent (chloroform) at a concentration of 1 mg/ml at 40°C to prepare a sample solution.

· Measurement Conditions

0.1 ml of the sample solution was introduced into the column with a solvent (chloroform) at a temperature of 40°C and a flow rate of 1 ml/min, and the concentration of the sample in the sample solution, separated by the column was measured using a differential refractometer. Then, the universal calibration curve was created using polystyrene standards, and Mw and Mw/Mn of the optically active polymer (PLA) were calculated.

<Measurement and Evaluation of Physical Properties of Film>

The film obtained above was measured for Re (ave), ΔRe, thickness, crystallinity, molecular orientation ratio MOR, and standardized molecular orientation ratio MORc. The product of the crystallinity and the standardized molecular orientation ratio MORc was also calculated.

The film obtained above was also evaluated for color non-uniformity (variation in phase difference).

The details are shown below.

The results of the measurement and evaluation of the physical properties are illustrated in Table 2 below.

(Measurement of Re (ave) and ΔRe)

The film obtained above was cut into a rectangular sample of 210 mm (in the uniaxial stretching direction) × 297 mm to give a sample for measurement of the Re.

The length to be measured was a length of 10 mm centered at the center of a principal plane of the resultant sample for measurement of the Re. The longitudinal direction of the length to be measured was the direction in which the ΔRe as described below was greatest. More particularly, in all of Examples and Comparative Examples, the direction in which the ΔRe was greatest was perpendicular to the molecular orientation (uniaxial stretching direction).

The retardation Re was measured at every 0.8 mm along the length of 10 mm at a wavelength of 550 nm. The Re was measured at 12 points.

From the 12 Re measurements, the average Re (ave) and the absolute difference ΔRe between the maximum and minimum Re were calculated.

The above values were measured using WPA-100 two-dimensional birefringence measurement system (from Photonic Lattice, Inc.).

(Crystallinity)

10 mg of the film obtained above was precisely weighed. And a melting endotherm curve was obtained by heating the film to 140°C at a temperature increase rate of 500°C/min and then heating the film to 200°C at a temperature increase rate of 10°C/min using a differential scanning calorimeter (DSC-1 from PerkinElmer, Inc.). From the melting endotherm curve, the crystallinity was determined.

(Molecular Orientation Ratio MOR)

The molecular orientation ratio MOR of the film obtained above was measured using MOA-6000 microwave molecular orientation meter from Oji Scientific Instruments Co., Ltd.

(Standardized Molecular Orientation Ratio MORc)

The standardized molecular orientation ratio MORc of the film obtained above was measured using MOA-6000 microwave molecular orientation meter from Oji Scientific Instruments Co., Ltd. The reference thickness tc was 50 μm.

(Internal Haze)

The internal haze (H1) of the film obtained above was measured by the following method.

First, a cell having a optical path length of 10 mm was filled with silicone oil (SHIN-ETSU SILICONE™ KF-96-100 CS from Shin-Etsu Chemical Co., Ltd.). The cell filled with the silicone oil was measured for haze in the direction of the optical path length (hereinafter referred to as "haze (H2)").

Next, the film obtained above was immersed in the silicone oil in the cell, and the cell with the film immersed therein was measured for the haze in the direction of the optical path length (hereinafter referred to as "haze (H3)").

Then, the difference between the hazes were calculated with the following formula to obtain the internal haze (H1).

$$\text{Internal Haze (H1)} = \text{Haze (H3)} - \text{Haze (H2)}$$

The haze (H2) and the haze (H3) were measured in the following measurement conditions using the following equipment:

Measurement Device: HAZE METER TC-HIII DPK from Tokyo Denshoku Co., Ltd.
Sample Size: width of 30 mm by length of 30 mm
Measurement Conditions: conditions in accordance with JIS-K7105
Measurement Temperature: room temperature (25°C)

(Piezoelectric Constant)

The piezoelectric constant ($d_{14}$) of the film obtained above was measured by the following method (stress-charge method).

The film was cut into a rectangular specimen having a length of 150 mm in the direction of 45° with respect to the stretching direction (for example, the MD direction) and a width of 50 mm in the direction perpendicular to the above 45° direction. Then, the resultant specimen was placed on the test platform of SIP-600 from Showa Shinku Co., Ltd., and Al was deposited on one surface of the specimen at an Al deposition thickness of about 50 nm. Then, Al is deposited on the other surface of the specimen in the same manner to provide the specimen having an Al conductive layer on the both surfaces.

The 150 mm × 50 mm specimen (film) having an Al conductive layer on the both surfaces was cut into a rectangular film having a length of 120 mm in the direction of 45° with respect to the stretching direction (the MD direction) and a width of 10 mm in the direction perpendicular to the above 45° direction. The film was used as a sample for measurement of the piezoelectric constant.

The resultant sample was tightly clamped into a tensile tester (TENSILON RTG-1250 from AND Co., Ltd) with a distance between chucks of 70 mm. Then, a force varying from 4N to 9N was periodically applied at a crosshead speed of 5 mm/min. To measure the amount of charge generated in the sample in response to the applied force, a capacitor having a capacitance of Qm (F) was connected in parallel with the sample, and the voltage V between the terminals of the capacitor Cm (95 nF) was measured via a buffer amplifier. The amount of charge stored on each plate Q (C) was calculated as the product of the capacitor capacitance Cm and the voltage between the terminals Vm. The piezoelectric constant $d_{14}$ was calculated with the following formula:

$$d_{14} = (2 \times t)/L \times Cm \cdot \Delta Vm/\Delta F$$

t: sample thickness (m)
L: distance between chucks (m)
Cm: capacitance of capacitor connected in parallel (F)
$\Delta Vm/\Delta F$: ratio of change in voltage between the terminals of capacitor to change in force

(Color Non-Uniformity (Variation in Phase Difference) of Film)

- Preparation of Polarizing Plates -

Two polarizing plates ("NPF-F1205DU" from Nitto Denko Corp.) were prepared.

- Evaluation of Color Non-Uniformity (Variation in Phase Difference) -

Next, the sample (film) for measurement of the Re was disposed between the two polarizing plates that are arranged in a crossed Nicols fashion to prepare a layered sample. The layered sample was irradiated by a fluorescent lamp, and the color non-uniformity was visually observed and evaluated by the following evaluation criteria:

- Evaluation Criteria -

A: No color non-uniformity was visually noticed.
B: Although slight color non-uniformity was visually noticed on the overall surface of the film, the non-uniformity was acceptable for practical use.
C: Color non-uniformity was visually noticed on the overall surface of the film, which was not acceptable for practical use.
D: Color non-uniformity was visually noticed on the overall surface of the film, and streaks having a width of about 1 mm were also noticed, which were not acceptable for practical use.

[Examples 2-3 and Comparative Examples 1-3]

The films were produced in the same manner as in Example 1 except that the production conditions were changed as illustrated in Table 1 below, and the films were measured and evaluated in the same manner as in Example 1.
The results of the measurement and the evaluation are illustrated in Table 2 below.

[Table 1]

| | Physical Properties of Polymer | | | | Thickness of Pre-Crystallized Film (μm) | Stretching Conditions | | | Annealing Temperature [°C] |
|---|---|---|---|---|---|---|---|---|---|
| | Chirality | Mw | Mw/Mn | Optical Purity (ee %) | | Method | Magnification | Temperature [°C] | |
| Example 1 | L | 200,000 | 2.87 | 98.5 | 220 | Continuous Uniaxial Stretching | 3.6 | 72.5 | 100/130/145/60 |
| Example 2 | L | 200,000 | 2.87 | 98.5 | 210 | Continuous Uniaxial Stretching | 3.6 | 72.5 | 100/130/145/60 |
| Example 3 | L | 200,000 | 2.87 | 98.5 | 130 | Continuous Uniaxial Stretching | 3.6 | 72.5 | 100/130/145/60 |
| Comparative Example 1 | L | 200,000 | 2.87 | 98.5 | 250 | Continuous Uniaxial Stretching | 3.6 | 73.0 | 100/130/145/60 |
| Comparative Example 2 | L | 200,000 | 2.87 | 98.5 | 180 | Continuous Uniaxial Stretching | 3.6 | 72.5 | 100/130/145/60 |
| Comparative Example 3 | L | 200,000 | 2.87 | 98.5 | 70 | Continuous Uniaxial Stretching | 3.6 | 71.0 | 100/130/145/60 |

[Table 2]

| | Physical Properties of Film | | | | | | | | | Evaluation Result of Color Non-Uniformity (Phase Difference) |
|---|---|---|---|---|---|---|---|---|---|---|
| | Re(ave) [nm] | ΔRe [nm] | Thickness [μm] | Crystallinity [%] | MOR | MORc (Reference Thickness: 50 μm) | MORc × Crystallinity | Internal Haze [%] | Piezoelectric Constant $d_{14}$ [pC/N] | |
| Example 1 | 1325 | 49.3 | 60 | 42.1 | 5.96 | 5.13 | 216 | 0.28 | 6.2 | B |
| Example 2 | 1320 | 54.3 | 58 | 41.2 | 5.67 | 5.03 | 207 | 0.27 | 6.1 | B |
| Example 3 | 815 | 31.7 | 37 | 44.6 | 3.44 | 4.30 | 192 | 0.20 | 6.0 | A |
| Comparative Example 1 | 1500 | 75.3 | 70 | 40.2 | 6.78 | 5.13 | 206 | 0.34 | 5.5 | C |
| Comparative Example 2 | 1054 | 27.3 | 50 | 47.6 | 4.88 | 4.88 | 233 | 0.22 | 6.1 | D |
| Comparative Example 3 | 463 | 27.3 | 21 | 41.8 | 2.14 | 3.72 | 155 | 0.14 | 6.3 | D |

As illustrated in Table 1 and Table 2, the films of Examples 1-3 having a ΔRe of 100 nm or less and a Re (ave) in a range of from 700 nm to 900 nm or in a range of from 1250 nm to 1450 nm exhibited reduced color non-uniformity.

In contrast, the films of Comparative Examples 1-3 having a Re (ave) outside of the above two ranges exhibited significant color non-uniformity.

Japanese Patent Application No. 2013-140900 filed on July 4, 2013 is herein incorporated by reference in its entireties.

All publications, patent applications, and technical specifications described herein are herein incorporated by reference to the same extent as if individual publication, patent application, and technical specification were specifically and individually indicated to be incorporated by reference.

## Claims

1. A film having a molecular orientation, the film having an absolute difference ΔRe between the maximum and minimum retardations Re of 100 nm or less in a case wherein the retardations Re are measured at every 0.8 mm along a measured length of 10 mm centered at the center of a principal plane of the film and at a wavelength of 550 nm, and having an average Re (ave) of the retardations Re in a range of from 700 nm to 900 nm or in a range of from 1250 nm to 1450 nm.

2. The film according to Claim 1, the film having a molecular orientation ratio MOR in a range of from 3.0 to 4.0 or in a range of from 5.5 to 6.5, as measured by a microwave molecular orientation meter.

3. The film according to Claim 2, the film having the average Re (ave) in a range of from 700 nm to 900 nm and the molecular orientation ratio MOR in a range of from 3.0 to 4.0, or having the average Re (ave) in a range of from 1250 nm to 1450 nm and the molecular orientation ratio MOR in a range of from 5.5 to 6.5.

4. The film according to Claim 1 or 2, the film comprising a helical chiral polymer having optical activity.

5. The film according to Claim 1 or 2, the film having the absolute difference ΔRe of from 20 nm to 100 nm.

6. The film according to Claim 1 or 2, the film having the absolute difference ΔRe of from 30 nm to 100 nm.

7. The film according to Claim 1 or 2, the film being a uniaxially stretched film.

8. The film according to Claim 1 or 2, the film comprising a helical chiral polymer that has optical activity and a weight-average molecular weight of from 50,000 to 1,000,000 and having a crystallinity of from 20% to 80% as obtained by a DSC method and a product of a standardized molecular orientation ratio MORc measured by a microwave molecular orientation meter based on a reference thickness of 50 μm and the crystallinity of from 25 to 700.

9. The film according to Claim 4, wherein the helical chiral polymer is a polylactic acid-type polymer that has a main chain having a repeating unit represented by the following Formula (1):

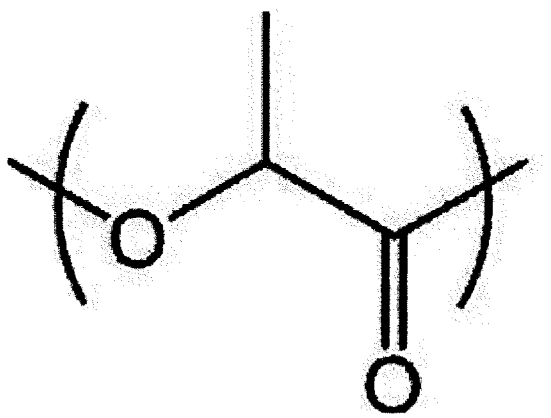

(1)

.

10. A polymeric piezoelectric material comprising the film according to Claim 1 or 2.

## INTERNATIONAL SEARCH REPORT

International application No.
PCT/JP2014/066075

A. CLASSIFICATION OF SUBJECT MATTER
*G02B5/30*(2006.01)i, *C08J5/18*(2006.01)i, *H01L41/193*(2006.01)i

According to International Patent Classification (IPC) or to both national classification and IPC

B. FIELDS SEARCHED

Minimum documentation searched (classification system followed by classification symbols)
G02B5/30, C08J5/18, H01L41/193

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2012/026494 A1 (Mitsui Chemicals, Inc.), 01 March 2012 (01.03.2012), paragraphs [0012], [0015] to [0019], [0023], [0034] to [0050], [0060], [0062] to [0063], [0097] to [0115] & JP 2012-235086 A & US 2012/0132846 A1 & EP 2469618 A1 & CN 102484199 A & KR 10-2012-0058536 A | 1-10 |
| Y | JP 2009-248445 A (Murata Mfg. Co., Ltd.), 29 October 2009 (29.10.2009), paragraphs [0033] to [0036] (Family: none) | 1-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>21 August, 2014 (21.08.14) | Date of mailing of the international search report<br>02 September, 2014 (02.09.14) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No. PCT/JP2014/066075

C (Continuation). DOCUMENTS CONSIDERED TO BE RELEVANT

| Category* | Citation of document, with indication, where appropriate, of the relevant passages | Relevant to claim No. |
|---|---|---|
| Y | JP 5-152638 A (Takiron Co., Ltd.), 18 June 1993 (18.06.1993), paragraphs [0007], [0016] to [0017] (Family: none) | 1-10 |
| Y | JP 2005-203590 A (Fuji Photo Film Co., Ltd.), 28 July 2005 (28.07.2005), paragraphs [0016], [0041] to [0043] (Family: none) | 1-10 |
| A | WO 2010/104196 A1 (Mitsui Chemicals, Inc.), 16 September 2010 (16.09.2010), entire text; all drawings & JP 5383790 B & US 2012/0025674 A1 & EP 2408034 A1 & CN 102349170 A & TW 201039474 A & KR 10-2011-0137361 A | 1-10 |
| A | JP 2012-232497 A (Teijin Ltd.), 29 November 2012 (29.11.2012), entire text; all drawings (Family: none) | 1-10 |
| A | JP 2005-213376 A (Mitsui Chemicals, Inc.), 11 August 2005 (11.08.2005), entire text (Family: none) | 1-10 |
| A | JP 2006-243610 A (Asahi Kasei Chemicals Corp.), 14 September 2006 (14.09.2006), entire text (Family: none) | 1-10 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010143528 A
- JP 2012007110 A
- JP S59096123 A
- JP H07033861 A
- US 2668182 A
- US 4057357 A
- WO 2013054918 A
- JP 2013140900 A